Europäisches Patentamt

European Patent Office

Office européen des brevets

(11) Veröffentlichungsnummer : **0 191 023
B1**

(12) **EUROPÄISCHE PATENTSCHRIFT**

(45) Veröffentlichungstag der Patentschrift :
**27.07.88**

(21) Anmeldenummer : **85902521.5**

(22) Anmeldetag : **14.05.85**

(86) Internationale Anmeldenummer :
**PCT/EP 85/00225**

(87) Internationale Veröffentlichungsnummer :
**WO/8600973 (13.02.86 Gazette 86/04)**

(51) Int. Cl.⁴ : **F 16 L 47/00, C 30 B 31/10,
C 30 B 35/00, B 01 L 3/00**

(54) **ROHRFÖRMIGES BAUTEIL AUS QUARZGLAS MIT FLANSCH.**

(30) Priorität : **18.07.84 DE 3426379**

(43) Veröffentlichungstag der Anmeldung :
**20.08.86 Patentblatt 86/34**

(45) Bekanntmachung des Hinweises auf die Patenterteilung : **27.07.88 Patentblatt 88/30**

(84) Benannte Vertragsstaaten :
**CH DE FR GB LI**

(56) Entgegenhaltungen :
**Keine Entgegenhaltungen**

(73) Patentinhaber : **HERAEUS QUARZSCHMELZE GMBH
Quarzstrasse
D-6450 Hanau (DE)**

(72) Erfinder : **SCHÜLKE, Karl, Albert
Humboldtstrasse 14
D-6451 Grosskrotzenburg (DE)**

(74) Vertreter : **Heinen, Gerhard, Dr.
W.C. Heraeus GmbH Zentralbereich Patente und
Lizenzen Heraeusstrasse 12-14
D-6450 Hanau (DE)**

**Beschreibung**

Die vorliegende Erfindung betrifft ein rohrförmiges Bauteil aus Quarzglas oder Quarzgut, wie ein Rohr, eine Glocke, eine Haube oder einen Tiegel, mit einem angeschmolzenen oder angeschweißten Flansch.

Ein solches rohrförmiges Bauteil, das beispielsweise in der Halbleiterfertigung eingesetzt wird, ist aus der DE-A-30 20 264 bekannt. Dieses Prozeßrohr weist einen im Vergleich zur Rohrwandung dickwandigen Flansch auf. Der Flansch kann auf seiner in radiale Richtung weisenden Stirnseite über einen darauf aufgesetzten Kühlkörper, der mit zwei Dichtungsringen gegenüber dem Flansch abgedichtet ist, mittels Kühlmittel, beispielsweise Wasser, gekühlt werden.

Im allgemeinen ist die Herstellung von Flanschen an großformatigen Glocken, Hauben, Tiegeln oder Rohren aus Quarzglas oder Quarzgut mit äußerst schwierigen fertigungstechnischen Problemen verbunden. Dies ist u. a. eine Folge davon, daß Rohre aus Quarzmaterial großen Fertigungstoleranzen unterliegen. So liegt beispielsweise die Toleranz eines Rohres mit einer Nennweite von 500 mm bei ± 20 mm. Diese Toleranzen sind aber oftmals nicht mit den geforderten Genauigkeitsanforderungen zu vereinen. Die Folge ist dann oft eine teure, mechanische Nacharbeit oder gar Totalausschuß wegen nichtkorrigierbarem Untermaß, insbesondere im Bereich des Flansches.

Ein weiteres Problem ist die Herstellung von rohrförmigen Bauteilen mit größeren Flanschformaten. Der Grund für die fertigungstechnischen Schwierigkeiten liegt darin, daß die herkömmlichen notwendigen Massenanhäufungen (häufig bis 40 mm Dicke und mehr) im Flanschbereich entweder nicht in situ erschmolzen oder, bei separater Herstellung des Flanschkörpers, nicht mehr angeschweißt werden können.

Flansche der herkömmlichen Art unterliegen auch Anwendungseinschränkungen. Quarzteile werden typischerweise bei hohen Temperaturen eingesetzt. Beim Einbau in Apparate werden hierbei deshalb häufig wassergekühlte Metall-Flansche mit elastischen Dichtungsteilen, beispielsweise O-Ringen, eingesetzt. Die Wasserkühlung von der Metallseite her soll hierbei verhindern, daß die Dichtungsteile zu stark erwärmt werden. Trotz der Kühlung verbrennen oder altern die herkömmlichen Flansche unter dem Einfluß der Wärmeleitung oder sogar Wärmestrahlung durch die relativ große Massenanhäufung im Flanschbereich.

Aus der DE-C-12 37 859 ist eine Flüssigkeitsdichtung mit einem in eine Nut eines der abzudichtenden Bauteile angeordneten Ringes aus flüssigem Metall bekannt.

Nach dem Stand der Technik wurden eine Vielzahl von Wegen und Lösungen angegeben, um die vorstehend aufgeführten Probleme, die bei großvolumigen Bauteilen aus Quarzmaterial mit einem Flansch auftreten, in den Griff zu bekommen und zu lösen.

Der vorliegenden Erfindung liegt nun die Aufgabe zugrunde, ein geeignetes rohrförmiges Bauteil großen Durchmessers mit Flansch zu schaffen, bei dem die Möglichkeit einer guten Kühlung insbesondere der Dichtflächen des Flansches gegeben ist, und bei dem Wärmeleitung und Wärmestrahlung im Bereich des Flansches weitgehenst vermieden wird.

Diese Aufgabe wird erfindungsgemäß dadurch gelöst, daß der Flansch als dünnwandiger Hohlflansch ausgebildet einen Hohlraum aufweist, dem gegebenenfalls ein Kühlmedium zugeführt werden kann (oder der mit einem wärmedämmenden Stoff füllbar ist). Durch die dünnwandige Ausbildung des Hohlflansches wird eine Massenanhäufung und daraus folgend eine große Wärmeleitung vermieden. Darüber hinaus kann ein etwaiges Kühlmedium vorteilhaft unmittelbar im Bereich der Kühlfläche und des Endabschnittes des rohrförmigen Bauteiles die Wärme abtransportieren. Ein weiterer Vorteil der Erfindung liegt in der Möglichkeit, großvolumige, aber dünnwandige Apparateteile mit einem Flansch von angemessener Größe, jedoch ohne eine unerwünschte Materialanhäufung, zu versehen, was insbesondere eine Folge der leichten Verformbarkeit des dünnwandigen Materials ist.

Besonders vorteilhaft ist ein Flansch aus einem im Querschnitt U-förmigen Bauteil. Ein solcher Flansch kann als gesondertes Bauteil gefertigt und entsprechend dimensioniert werden. Besonders gut bewährt hat es sich, ein U-förmiges Flanschteil mit einem längeren und einem kürzeren Schenkel, wobei der längere Schenkel die Stirnseite des rohrförmigen Bauteiles zumindest teilweise überdeckt. Bekanntlich ist ein Teil aus Quarzgut an seiner Innenwand sehr massiv dicht und gut verschmolzen, und zwar in einer Tiefe von etwa 2 bis 3 mm. In den äußeren Wandschichten sind aber zahlreiche Lunker von 0,5 mm Größe enthalten, also auch im äußeren Bereich der Stirnfläche des rohrförmigen Bauteiles. Dadurch aber, daß das U-förmige Bauteil über diese Stirnfläche des rohrförmigen Bauteiles gezogen ist, werden gerade diese Lunker aufweisenden Bereiche wirkungsvoll abgedeckt.

Ein Flansch mit hoher Festigkeit ergibt sich dann, wenn die Verbindungsfläche zwischen den beiden Schenkeln des im Querschnitt U-förmigen Flanschteiles zum Rohrende hin in Richtung des Rohrinneren hin geneigt verläuft. Ein Neigungswinkel der Verbindungsfläche zur Rohrachse von etwa 15 bis 30° hat sich hierbei gut bewährt.

Je nach Durchmesser des rohrförmigen Bauteils und der Größe des Flansches sollte die Wandstärke des Flansches etwa 4 bis 10 mm betragen.

In vorteilhafter Weise werden zur Zu- und Ableitung des Kühlmediums zwei Anschlußstutzen an sich diametral gegenüberliegenden Stellen, bevorzugt in der Verbindungsfläche, angeordnet.

Mit einer solchen Ausgestaltung des Kühlsystems ist es nicht erforderlich, in den Hohlraum Zwischenwände für einen Zu- bzw. Ablaufkanal einzuziehen. Die Kühlung erfolgt im Durchfluß ohne besondere zusätzliche konstruktive Maßnahmen.

Weitere Einzelheiten und Merkmale der Erfindung ergeben sich aus der nachfolgenden Beschreibung eines Ausführungsbeispieles anhand der Zeichnung. In der Zeichnung zeigt

Figur 1 die eine Hälfte eines rohrförmigen Bauteiles mit einem erfindungsgemäßen Flansch, das mit einem Deckel verschlossen ist,

Figur 2 einen U-förmigen Flansch, der als gesondertes Bauteil in die Wandung des rohrförmigen Bauteiles eingeschmolzen ist,

Figur 3 einen Flansch, der an das Ende des rohrförmigen Bauteils angeschweißt ist und

Figur 4 einen Flansch in einer abgewandelten Ausführungsform.

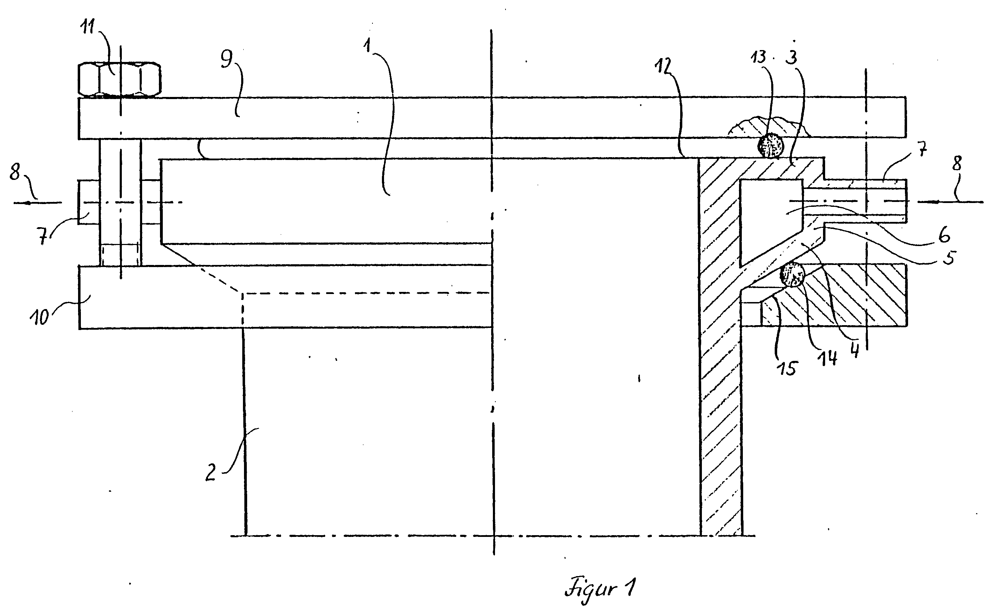

Wie aus Figur 1 ersichtlich ist, weist der Flansch 1, der am Ende eines rohrförmigen Bauteiles 2 angeordnet ist, im wesentlichen einen U-förmigen Querschnitt mit zwei Schenkeln 3, 4 und eine die beiden Schenkel verbindenden Verbindungsfläche 5 auf. Der U-förmige Flansch 1 umschließt zusammen mit der Wand des rohrförmigen Bauteiles 2 einen Hohlraum 6, in dem über einen Anschlußstutzen 7 ein Kühlmedium 8, beispielsweise Wasser oder Gas, zu- bzw. abgeführt wird. In der Figur 1 wird das rohrförmige Bauteil 2 aus Quarz mit einem Deckel 9 über einen Spannring 10 und Spannschrauben 11 verschlossen. Sowohl zwischen dem Deckel 9 und der Dichtfläche 12 des Flansches 1 als auch zwischen dem Spannring 10 und dem oberen Schenkel 4 ist jeweils ein Dichtring 13, 14, im vorliegenden Fall ein O-Ring, eingelegt. Der obere Schenkel 4 des Flansches 1 verläuft zur Wand des rohrförmigen Bauteiles 2 geneigt, so daß der Hohlraum 6 von der Außenseite zum Bauteil 2 hin vergrößert ist. Die Klemmfläche 15 des Spannringes 10 ist parallel zu der Außenfläche des Schenkels 4 abgeschrägt.

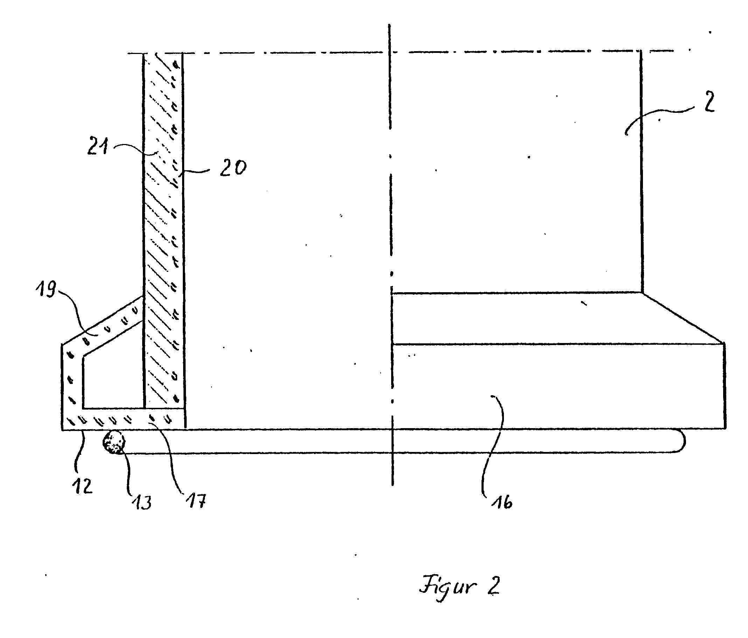

Bei dem in Figur 2 gezeigten Flansch 16 ist dessen unterer Schenkel 17 länger ausgeführt als der obere, an der Rohrwand anliegende, schräg verlaufende Schenkel 19. Hier besteht die Gefäßwand, entsprechend zu Figur 1, aus Quarzgut, das an seiner Innenwand 20 sehr massiv, dicht und gut in einer Tiefe von etwa 2 bis 3 mm verschmolzen ist, aber im übrigen äußeren Bereich 21 zahlreiche Lunker von typischerweise 0,5 mm Größe enthält. Damit diese Lunker unwirksam werden und insbesondere die gesamte axiale Dichtungsfläche 12 zum Dichtring 13 hin optimal abgedichtet wird, wird in diesem Ausführungsbeispiel der untere, länger ausgebildete Schenkel 17 über die gesamte Stirnfläche des rohrförmigen Bauteiles 2 gezogen.

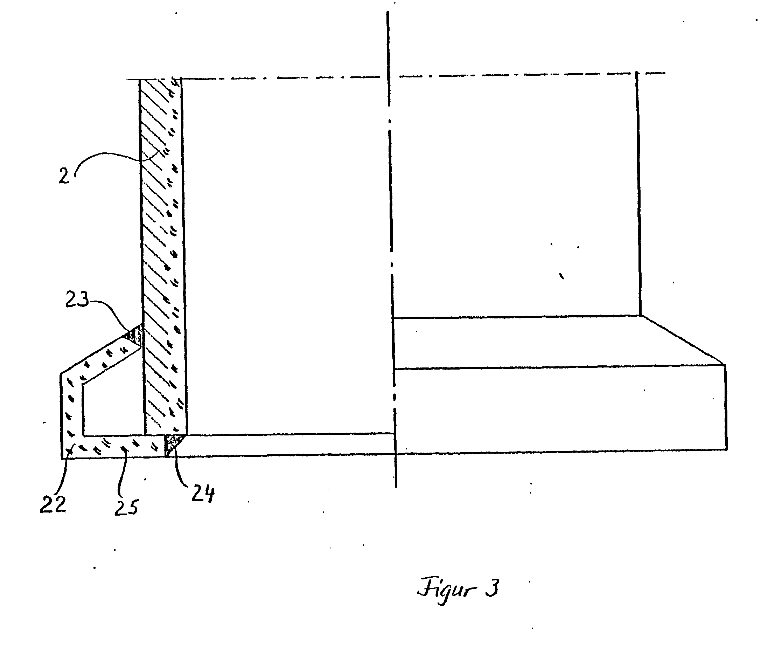

Der in Figur 3 dargestellte Flansch 22 ist als gesondertes Bauteil gefertigt und nachträglich an dem rohrförmigen Bauteil 2 mit seinen Schenkeln an den Stellen 23, 24 angeschweißt. Stirnseitig bedeckt der Schenkel 25, der die Dichtfläche bildet, nur den Bereich der Stirnseite des rohrförmigen Bauteiles, der im wesentlichen die Lunker aufweist.

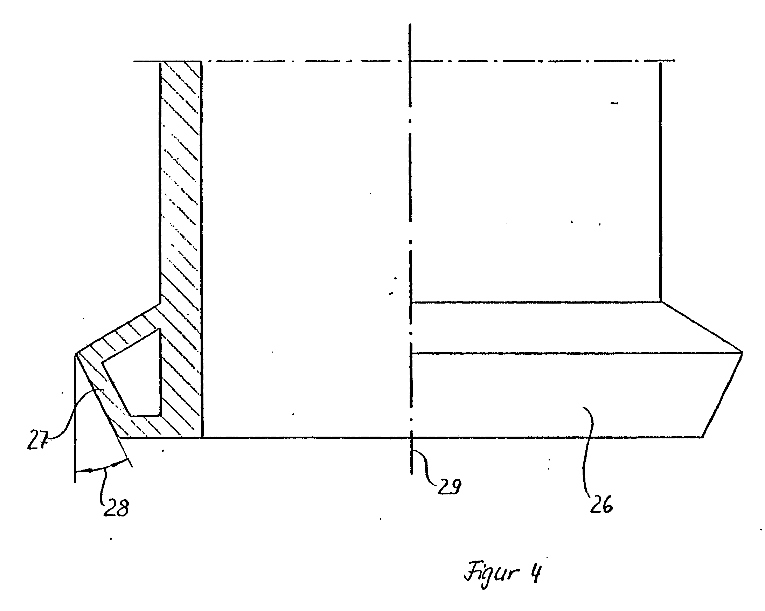

Der in Figur 4 gezeigte Aufbau entspricht im wesentlichen dem in Figur 1 gezeigten Aufbau. In diesem Ausführungsbeispiel ist jedoch ein Flansch 26 eingesetzt, dessen Verbindungsfläche 27 in einem Winkel 28 von etwa 25° aus der durch die strichpunktierte Linie 29 angedeuteten Rohrachse zum Rohrende hin in Richtung des Rohrinneren geneigt verläuft.

Unter Umständen, falls eine Kühlung mit einem flüssigen Kühlmedium nicht erforderlich ist, kann der Hohlraum 6 des Flansches auch mit Granulat oder Sand gefüllt sein.

Die gezeigten Flansche eignen sich insbesondere für Gasphasen-Epitaxie-Glocken, bei denen hohe Anforderungen an die Dichteigenschaften gestellt werden.

**Patentansprüche**

1. Rohrförmiges Bauteil (2) aus Quarzglas oder Quarzgut, wie ein Rohr, eine Glocke, eine Haube oder ein Tiegel, mit einem angeschmolzenen oder angeschweißten Flansch (1, 16, 22, 26) dadurch gekennzeichnet, daß der Flansch (1 ; 16 ; 22 ; 26) als dünnwandiger Hohlflansch ausgebildet ist.

2. Rohrförmiges Bauteil nach Anspruch 1, dadurch gekennzeichnet, daß der Hohlraum mit einem Kühlmedium, vorzugsweise Wasser oder Gas, oder einem wärmedämmenden Stoff gefüllt ist.

3. Rohrförmiges Bauteil nach Anspruch 1, dadurch gekennzeichnet, daß der Flansch (1 ; 16 ; 22 ; 26) ein im Querschnitt etwa U-förmiges bzw. trogförmiges Bauteil ist.

4. Rohrförmiges Bauteil mit Flansch nach Anspruch 3, dadurch gekennzeichnet, daß das im Querschnitt U-förmige bzw. trogförmige Flanschteil (16 ; 22 ; 26) einen längeren und einen kürzeren Schenkel (19) aufweist, wobei der längere Schenkel (17) die Stirnseite des rohrförmigen Bauteiles (2) zumindest teilweise abdeckend angeordnet ist, und daß beide Schenkel abgedichtet mit dem Bauteil verbunden sind.

5. Rohrförmiges Bauteil nach Anspruch 3 oder 4, dadurch gekennzeichnet, daß die Verbindungsfläche (27) zwischen den beiden Schenkeln des U-förmigen Flanschteiles (26) zum Rohrende hin in Richtung des Rohrinnern geneigt verläuft.

6. Rohrförmiges Bauteil nach Anspruch 5, dadurch gekennzeichnet, daß die Verbindungsfläche (27) unter einem Winkel (28) von etwa 15 bis 30° zur Rohrachse (29) geneigt verläuft.

7. Rohrförmiges Bauteil nach einem der Ansprüche 1 bis 6, dadurch gekennzeichnet, daß die Wandstärke des Flansches (1 ; 16 ; 22 ; 26) 4 bis 10 mm beträgt.

8. Rohrförmiges Bauteil nach Anspruch 2, dadurch gekennzeichnet, daß an zwei sich diametral gegenüberliegenden Stellen des Flansches (1 ; 16 ; 22 ; 26) jeweils ein Anschlußstutzen (7) für die Kühlmittelzufuhr und -abfuhr angeordnet ist.

9. Rohrförmiges Bauteil nach einem der Ansprüche 1 bis 7, dadurch gekennzeichnet, daß es eine Gasphasen-Epitaxie-Glocke für die Wärmebehandlung von Halbleitersubstraten ist.

**Claims**

1. Tubular component (2) of quarz glass or quarz material, such as a pipe, a bell, a dome or a crucible, having a flange fused or welded to it (1, 16, 22, 26), characterised in that the flange (1 ; 16 ; 22 ; 26) is produced as a thin-walled hollow flange.

2. Tubular component according to claim 1, characterised in that the cavity is filled with a coolant, preferably water or gas, or with a heat-insulating substance.

3. Tubular component according to claim 1, characterised in that the flange (1 ; 16 ; 22 ; 26) is a component of approximately U-shaped or trough-shaped cross-section.

4. Tubular component comprising a flange according to claim 3, characterised in that the flange element (16 ; 22 ; 26) of U-shaped or trough-shaped cross-section has one longer and one shorter branch (19), the longer branch (17) being arranged to at least partly cover the end face of the tubular component (2), and that both branches are joined in a sealed manner to the component.

5. Tubular component according to claim 3 or 4, characterised in that the connecting surface (27) between the two branches of the U-shaped flange element (26) extends slopingly towards the tube end, in a direction towards the inside of the tube.

6. Tubular component according to claim 5, characterised in that the connecting surface (27) extends slopingly at an angle (28) of about 15 to 30° with respect to the tube axis (29).

7. Tubular component according to one of the claims 1 to 6, characterised in that the wall thickness of the flange (1 ; 16 ; 22 ; 26) amounts to 4 to 10 mm.

8. Tubular component according to claim 2, characterised in that a connector stub (7) for the coolant inflow and outflow is situated at each of two diametrically opposed points of the flange (1 ; 16 ; 22 ; 26).

9. Tubular component according to one of the claims 1 to 7, characterised in that it is a gaseous phase epitaxy bell for the heat processing of semiconductor substrates.

**Revendications**

1. Elément tubulaire (2) en verre de quartz ou en verre de silice, comme un tube, une cloche, une calotte ou un creuset, présentant une bride (1 ; 16 ; 22 ; 26) rapportée par fusion ou par soudage, caractérisé en ce que la bride (1 ; 16 ; 22 ; 26) est réalisée sous forme de bride creuse à paroi mince.

2. Elément tubulaire selon la revendication 1, caractérisé en ce que l'espace creux est rempli d'un fluide de refroidissement, de préférence de l'eau ou du gaz, ou d'un matériau thermiquement isolant.

3. Elément tubulaire selon la revendication 1, caractérisé en ce que la bride (1 ; 16 ; 22 ; 26) est un élément de section à peu près en forme de U ou en forme d'auge.

4. Elément tubulaire à bride, selon la revendication 3, caractérisé en ce que la partie bride (16 ; 22 ; 26) qui a en coupe la forme d'un U ou d'une auge, présente une aile plus longue et une aile (19) plus courte, l'aile plus longue (17) étant disposée de façon à recouvrir au moins partiellement la face frontale de l'élément tubulaire (2) ; et en ce que les deux ailes sont reliées, avec étanchéité, à l'élément.

5. Elément tubulaire selon la revendication 3 ou 4, caractérisé en ce que la surface de liaison (27) entre les deux ailes de la partie bride (26) en forme de U va vers l'extrémité du tube en s'inclinant en direction de l'intérieur du tube.

6. Elément tubulaire selon la revendication 5, caractérisé en ce que la surface de liaison (27) va en s'inclinant sous un angle (28) d'environ 15 à 30° par rapport à l'axe (29) du tube.

7. Elément tubulaire selon l'une des revendications 1 à 6, caractérisé en ce que l'épaisseur de paroi de la bride (1 ; 16 ; 22 ; 26) atteint 4 à 10 mm.

8. Elément tubulaire selon la revendication 2, caractérisé en ce qu'en deux endroits, diamétralement opposés, de la bride (1 ; 16 ; 22 ; 26) est chaque fois disposée une tubulure de raccordement (7) pour l'arrivée et le départ du fluide de refroidissement.

9. Elément tubulaire selon l'une des revendications 1 à 7, caractérisé en ce qu'il est une cloche pour épitaxie en phase gazeuse pour le traitement thermique de substrats semi-conducteurs.

*Figur 1*

0 191 023

Figur 2

0 191 023

Figur 3

Figur 4